(19) Europäisches Patentamt
European Patent Office
Office européen des brevets

(11) EP 2 391 631 B1

(12) FASCICULE DE BREVET EUROPEEN

(45) Date de publication et mention de la délivrance du brevet:
**11.03.2015 Bulletin 2015/11**

(21) Numéro de dépôt: **10707595.4**

(22) Date de dépôt: **27.01.2010**

(51) Int Cl.:
***C07F 15/02*** (2006.01) ***G01K 11/12*** (2006.01)
***G11C 13/04*** (2006.01) ***G11B 7/246*** (2013.01)

(86) Numéro de dépôt international:
**PCT/FR2010/050122**

(87) Numéro de publication internationale:
**WO 2010/086550 (05.08.2010 Gazette 2010/31)**

# (54) NOUVEAU MATERIAU A TRANSITION DE SPIN, SON PROCEDE DE PREPARATION

NEUES MATERIAL MIT SPINNÜBERGANG UND VERFAHREN ZU DESSEN HERSTELLUNG

NOVEL MATERIAL WITH SPIN TRANSITION, AND METHOD FOR MAKING SAME

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **28.01.2009 FR 0900368**

(43) Date de publication de la demande:
**07.12.2011 Bulletin 2011/49**

(73) Titulaire: **Centre National de la Recherche Scientifique**
**75016 Paris (FR)**

(72) Inventeurs:
- **LETARD, Jean-François**
**F-33610 Canejan (FR)**
- **DARO, Nathalie**
**F-33600 Pessac (FR)**
- **AYMONIER, Cyril**
**F-33130 Begles (FR)**
- **CANSELL, François**
**F-33600 Pessac (FR)**
- **SAINT-MARTIN, Sabine**
**F-33000 Bordeaux (FR)**

(74) Mandataire: **Goulard, Sophie et al**
**Ipsilon Brema-Loyer**
**Le Centralis**
**63, avenue du Général Leclerc**
**92340 Bourg-la-Reine (FR)**

(56) Documents cités:
**WO-A-2007/065996 FR-A- 2 917 410**

- **ARNAUD C ET AL: "Observation of an asymmetry in the thermal hysteresis loop at the scale of a single spin-crossover particle" CHEMICAL PHYSICS LETTERS 20090224 ELSEVIER NL, vol. 470, no. 1-3, 13 janvier 2009 (2009-01-13), pages 131-135, XP002530694**
- **AYMONIER ET AL: "Review of supercritical fluids in inorganic materials science" JOURNAL OF SUPERCRITICAL FLUIDS, PRA PRESS, US, vol. 38, no. 2, 1 septembre 2006 (2006-09-01), pages 242-251, XP005670497 ISSN: 0896-8446**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).



Printed by Jouve, 75001 PARIS (FR)

## Description

La présente invention concerne un matériau constitué par des particules comprenant essentiellement un composé à transition de spin, un procédé pour la préparation dudit matériau, ainsi que diverses applications du matériau.

Il est connu d'utiliser des composés qui présentent une transition de spin pour diverses applications, notamment pour le stockage d'information. De tels composés peuvent être des complexes de coordination contenant un ou plusieurs centres métalliques ayant une configuration $3d^4$, $3d^6$ ou $3d^7$, un ou plusieurs ligands azotés, et un ou plusieurs anions, tels que décrits par exemple dans EP-0 543 465, EP-0 666 561, EP-0 745 986, EP-0 842 988 et WO2007/065996.

EP-0 543 465 décrit des composés à transition de spin et leur utilisation pour le stockage d'information. Certains de ces composés répondent à l'une des formules suivantes :

- $FeL_3(NO_3)_2$ dans laquelle L est un ligand du type 1,2,4-triazole ou 4-amino-1,2,4-triazole associé à l'anion $NO_3^-$ ;
- $Fe(ATP)_2$,$5Cl_2$, dans laquelle le ligand ATP est le 4-amino-1,2,4-triazole associé à Fe(II) et à Cl- ;
- $Fe(TP)_2Cl_2$ dans laquelle le ligand TP est le 1,2,4-triazole, associé à $Cl^-$ ;
- [Fe(2-aminométhylpyridine)$_3$]$Cl_2$EtOH, EtOH étant l'éthanol ;
- [Fe(1,10-phénanthroline)$_2$]$(NCS)_2$ ;
- [Fe(1-propyltétrazole)$_6$]$(BF_4)_2$.

D'autres composés de EP-0 543 465 sont des complexes d'un métal M associé à un mélange de plusieurs ligands (choisis parmi R-Trz, les amines $NL_2$ et les triazolates Trz-, M étant Fe(II), Fe(III) ou Co(II), R-Trz étant un triazole portant un substituant R, R et L étant un alkyle ou H), et à un anion choisi parmi BF4$^-$, $ClO_4^-$, $CO_3^{2-}$, $Br^-$, $Cl^-$, le complexe contenant en outre une quantité définie d'eau.

A l'exception du [Fe(1,10-phénanthroline)$_2$(NCS)$_2$], ces composés sont roses dans l'état bas spin (BS), et blancs dans l'état haut spin (HS). La transition est provoquée par chauffage ou refroidissement et a lieu entre -20°C et +100°C. Le phénomène d'hystérésis peut aller de quelques degrés à quelques dizaines de degrés suivant les composés.

EP-0 666 561 décrit des composés à transition de spin qui répondent à la formule Fe(II)(H-Trz)$_3$(X)$_2$ dans laquelle Trz est le 1,2,4-triazole, (X)$_2$ représente l'anion (BF4$^-$)$_2$, ($ClO_4^-$)$_2$, ($Br^-$)$_2$, ($Cl^-$)$_2$ ou ($CO_3^{2-}$). Ces composés présentent deux phases cristallines ayant chacune des transitions de spin associées à un changement de couleur (blanc/rose) et dont les températures $T_{1/2}\downarrow$ et $T_{1/2}\uparrow$ sont, respectivement, inférieures et supérieures à la température ambiante.

EP-0 745 986 décrit des composés répondant à une formule analogue à celle des composés de EP-0 543 465, dans laquelle M est un ion métallique en configuration d5, d6 ou d7, le ligand est un dialkylaminotriazole, l'anion comporte un groupe sulfitoaryle, sulfitoalkyle, sulfito halogénure d'aryle ou d'alkyle. Ces composés particuliers ont une amplitude d'hystérésis supérieure à 70°C, et une région de bistabilité centrée exactement autour de la température ambiante. Lesdits composés sont roses à l'état BS et blancs à l'état HS.

EP-0 842 988 décrit des composés chimiques à transition de spin et leur utilisation dans des dispositifs d'affichage de dépassement de seuil de température. Les composés sont formés par un réseau constitué par des molécules formées chacune par un complexe métal-ligand et par un anion, et ils comprennent au moins une molécule d'eau liée au ligand par liaison hydrogène. Le métal est choisi parmi ceux qui ont une configuration d4, d5, d6 ou d7. Le ligand est le 1,2,4-triazole portant un substituant R comprenant un groupe OH. Les anions sont des dérivés du tosylate et du nitrate. Les composés répondant à cette définition ont une température $T_{1/2}\uparrow$ comprise entre 80 et 95°C et $T_{1/2}\downarrow$ de -170°C. Ils peuvent être utilisés notamment dans des dispositifs destinés à détecter une température de stockage accidentellement élevée (de l'ordre de 80°C) dans des bâtiments de stockage ou des véhicules de transport.

Les composés obtenus selon les techniques ci-dessus sont de taille micrométrique et doivent être tamisés pour être utilisables comme pigments thermochromes dans des films de polymère ayant une épaisseur micrométrique. Toutefois, la taille micrométrique est incompatible avec l'obtention de support de données dans des microsystèmes pour du stockage en volume (holographie), les supports devant rester transparents.

WO2007/065996 décrit un procédé pour l'obtention directe de nanoparticules d'un matériau à transition de spin, constitué par un complexe de Fer, d'un ligand triazole et d'au moins un anion, et capable de changer d'état de spin de manière réversible lors d'un réchauffement et lors d'un refroidissement, avec un changement de couleur associé à chaque changement de spin.

FR 2 917 410 décrit des matériaux à transition de spin dont la couleur varie entre des combinaisons autres que blanc/rose lors de la transition. Ces matériaux sont constitués par au moins un composé répondant à la formule $AX_bY_c$ (I) dans laquelle A répond à la formule $Fe_{l-m}M_m(R\text{-}Trz)_3$ ; M est un métal ayant une configuration $3d^4$, $3d^5$, $3d^6$ ou $3d^7$, autre que Fe ; $0 \leq m \leq 1$ ; R-Trz représente un ligand 1,2,4-triazole portant un substituant R sur l'azote en position 4 ; R est un groupe alkyle ou un groupe $R^1R^2N$- dans lequel $R^1$ et $R^2$ représentent chacun indépendamment de l'autre H ou un radical alkyle ; X représente au moins un anion monovalent ou divalent; Y représente au moins un anion qui a un groupe chromophore ; et b et c sont choisis de telle sorte que l'électroneutralité du composé (I) soit respectée.

Arnaud et al. [Chem. Phys. Lett., 2009, 470, 131-135] décrivent un procédé de préparation d'un matériau à

transition de spin de formule $[Fe(NH_2\text{-}Trz)_3(Br)_2\text{-}2{,}5\ H_2O$ dans laquelle $NH_2$-Trz est le 4-amino-1,2,4-triazole.

Parmi les nombreux matériaux à transition de spin de l'art antérieur, certains présentent des propriétés intéressantes notamment du point de vue des températures de transition et des couleurs de transition. La qualité d'un matériau à transition de spin augmente notamment avec le caractère abrupt de la transition et l'hystérésis.

Aymonier et al. [J. Supercritical Fluids, 2006, 38(2), 242-252] décrivent l'utilisation de fluides supercritiques tels que le $CO_2$ supercritique pour le traitement de matériaux inorganiques, notamment pour contrôler leur taille, leur morphologie, leur structure et/ou leur composition.

Les inventeurs ont trouvé que, de manière surprenante, l'une au moins de ces deux propriétés augmentait lorsque les particules d'un matériau à transition de spin en dispersion dans un solvant organique polaire sont soumises à un traitement par du $CO_2$ supercritique dans des conditions de température et de pression convenablement sélectionnées.

Un tel procédé permet d'obtenir un matériau à transition de spin sous forme de particules, qui subit un changement de couleur lors d'un refroidissement ou d'un réchauffement avec un caractère abrupt et une hystérésis améliorés.

L'invention a donc pour premier objet un procédé de préparation d'un matériau à transition de spin sous forme de particules, caractérisé en ce qu'il consiste :

- dans une première étape, à préparer une dispersion de particules d'un matériau à transition de spin dans un solvant organique polaire dont la constante diélectrique, mesurée à 25°C, est supérieure à 19, puis
- dans une deuxième étape, à réaliser une mise en contact de la dispersion de particules ainsi obtenue avec du $CO_2$ supercritique à une température T et à une pression P remplissant les trois conditions suivantes :

  1) $40 \leq T \leq 150°C$;
  2) $150 \leq P \leq 250$ bars et
  3) $P.T > 6000$,

  et en ce que le matériau à transition de spin est choisi parmi un matériau (II) constitué par au moins un composé répondant à la formule (II) suivante :

$$AX_bY_c \qquad (II)$$

dans laquelle :

- A répond à la formule $Fe(R\text{-}Trz)_3$ ;
- R-Trz représente un ligand 1,2,4-triazole portant un substituant R sur l'azote en position 4 ;
- R est un groupe méthyle ou un groupe $R^1R^2N$- dans lequel $R^1$ et $R^2$ représentent chacun indépendamment de l'autre H ou un radical méthyle ;
- X représente au moins un anion monovalent ou divalent ;
- Y représente au moins un anion qui a un groupe chromophore ;
- b et c sont choisis de telle sorte que l'électroneutralité du composé (II) soit respectée, et

un matériau (I) constitué par des particules nanométriques comprenant essentiellement un composé répondant à la formule (I) suivante :

$$\left[(FeL_3)_w L_3\right]\left[X'_{2/x\left(1-z/x'\right)}\,Y'_{2z/x'}\right]_w \quad (I)$$

dans laquelle :

- L représente un ligand 1,2,4-triazole portant un substituant R sur l'azote en position 4 ;
- X' est un anion ayant la valence x, $1 \leq x \leq 2$ ;
- Y' est un anion différent de X ayant la valence x', $1 \leq x' \leq 2$ ;
- R est un groupe méthyle ou un groupe $R^1R^2N$- dans lequel $R^1$ et $R^2$ représentent chacun indépendamment de l'autre H ou un radical méthyle ;
- $0 \leq z \leq 2$ et $3 \leq w \leq 1500$.

Les Inventeurs ont en effet établi que, lorsque des particules d'un matériau à transition de spin (MTS) sont soumises à du $CO_2$SC dans les conditions définies ci-dessus, lesdites particules deviennent alors capables de changer de couleur de façon plus abrupte lors d'un changement de température de faible amplitude.

Dans le présent texte, $\Delta T_{30/20}\uparrow$ et $\Delta T_{80/20}\downarrow$ représentent respectivement l'écart en degrés Celsius nécessaire à la transition de phase des particules de MTS en mode chauffage ou en mode refroidissement pour passer de 80 à 20 % de fraction ayant subi une transition de phase. On considère qu'il n'y pas de changement de transition de phase lorsque $\Delta T_{80/20}\uparrow$ ou $\Delta T_{80/20}\downarrow$ est supérieur à 18°C ; qu'il y a une légère amélioration du caractère abrupt de la transition de phase lorsque $\Delta T_{80/20}\uparrow$ ou $\Delta T_{80/20}\downarrow$ va de 8 à 18 °C et que la transition de phase est particulièrement abrupte lorsque $\Delta T_{80/20}\uparrow$ ou $\Delta T_{80/20}\downarrow$ est inférieur à 8°C.

Le matériau obtenu par le procédé de préparation conforme à l'invention présente de préférence un $\Delta T_{80/20}\uparrow$ et/ou un $\Delta T_{80/20}\downarrow$ inférieur ou égal à 10°C et encore plus préférentiellement inférieur ou égal à 8°C.

Le procédé conforme à l'invention est bien entendu applicable à des matériaux présentant naturellement un $\Delta T_{80/20}\uparrow$ et/ou un $\Delta T_{80/20}\downarrow$ inférieur ou égal à 10°C dans le but d'accentuer encore plus le caractère abrupt de la transition de phase, de façon à obtenir, par exemple, des matériaux dans lesquels $\Delta T_{80/20}\uparrow$ et/ou $\Delta T_{80/20}\downarrow$ est inférieur à 8, voire inférieur à 5.

La constante diélectrique d'un solvant organique ($\varepsilon$) reflète son caractère polaire. Un solvant est dit polaire lorsqu'il peut séparer des ions les uns des autres. Généralement, un solvant ayant un $\varepsilon$ supérieur à 15 est déclaré solvant polaire et un solvant ayant un $\varepsilon$ inférieur à 15 est déclaré solvant non polaire. Toutes les valeurs de $\varepsilon$ données dans ce document ont été mesurées à une température de 25°C.

Selon une forme de réalisation particulière du procédé de l'invention, lorsque le solvant polaire a une constante diélectrique telle que $19 < \varepsilon \leq 25$, alors la température et la pression sont choisies de telle sorte que le produit P.T soit supérieur ou égal à 12000.

Selon une autre forme de réalisation particulière du procédé de l'invention, lorsque le solvant polaire a une constante diélectrique $\varepsilon > 25$, alors la température et la pression sont choisies de telle sorte que le produit P.T soit supérieur ou égal à 10000.

Selon le procédé conforme à l'invention, le solvant organique est de préférence choisi parmi les solvants dont la constante diélectrique $\varepsilon$ est inférieure ou égale à 40.

Parmi de tels solvants, on peut en particulier citer l'isopropanol ($\varepsilon$ = 20,2), l'acétone ($\varepsilon$ = 21,0), l'éthanol ($\varepsilon$ = 25,3), le méthanol ($\varepsilon$ = 33), le diméthylformamide ($\varepsilon$ = 37) et l'acétonitrile ($\varepsilon$ = 38).

Parmi de tels solvants, l'éthanol et le méthanol sont particulièrement préférés.

Le tableau I ci-après regroupe, pour des solvants utilisables conformément au procédé de l'invention, des exemples de conditions de température et de pression conduisant de façon générale à un MTS pour lequel le $\Delta T_{80/20}\uparrow$ et/ou le $\Delta T_{80/20}\downarrow$ est inférieur ou égal à 10°C.

**Tableau I**

| Solvant | $\varepsilon$ | T (°C) | P (bars) | T.P | $\Delta T_{80/20}\uparrow$ (°C) | $\Delta T_{80/20}\downarrow$(°C) |
|---|---|---|---|---|---|---|
| Isopropanol | 20,2 | 80 | 250 | 20000 | 6 | 5 |
| Acétone | 21,0 | 80 | 250 | 20000 | 4 | 7 |
| Ethanol | 25,3 | 40 | 250 | 10000 | 7 | 10 |
| Ethanol | 25,3 | 80 | 150 | 12000 | 6 | 5 |
| Ethanol | 25,3 | 80 | 250 | 20000 | 7 | 6 |
| Ethanol | 25,3 | 120 | 150 | 18000 | 5 | 5 |
| Méthanol | 33,0 | 80 | 150 | 12000 | 8 | 7 |
| Méthanol | 33,0 | 80 | 250 | 20000 | 7 | 4 |

Dans un 1$^{er}$ mode de réalisation, la mise en contact est effectuée par pulvérisation de $CO_2$SC dans la dispersion de particules. Ce premier mode de réalisation est dénommé procédé G.A.S. d'après l'expression anglaise « Gas Anti Solvent ».

Dans un 2$^{ème}$ mode de réalisation, la mise en contact est effectuée par pulvérisation de la dispersion de particules dans $CO_2$SC. Ce deuxième mode de réalisation est dénommé procédé P.C.A. d'après l'expression anglaise « Précipitation with Compressed Anti solvent ». Dans ce mode de réalisation, une diminution de la dimension des gouttelettes de la dispersion de particules favorise la pénétration du fluide supercritique dans lesdites gouttelettes.

Selon une forme de réalisation particulière de l'invention, le solvant organique peut en outre renfermer un

polymère. Dans ce cas, le procédé conforme à l'invention comprend une étape supplémentaire au cours de laquelle au moins un polymère est dissous dans le solvant organique avant d'y disperser les particules. La mise en contact est alors de préférence effectuée selon le procédé P.C.A.. Lors de la mise en contact, $CO_2SC$ se dissout dans la solution de polymère. Il en résulte une expansion du milieu réactionnel et une diminution du pouvoir de solvatation du solvant organique. La saturation en polymère du milieu réactionnel fait précipiter le polymère sur la surface des particules de matériau à transition de spin et conduit ainsi à des particules constituées d'un MTS enrobé par une couche de polymère.

Les polymères utilisables selon cette forme de réalisation particulière du procédé de l'invention sont choisis parmi les polymères solubles dans le solvant utilisé pour disperser les particules de MTS.

Lorsqu'ils sont présents, le ou les polymères représentent généralement de 0,1 à 15 % en poids, plus préférentiellement de 1 à 5 % en poids par rapport au poids total des particules de MTS dispersées dans le solvant.

A l'issue de l'étape de mise en contact avec $CO_2SC$, les particules du MTS sont récupérées par évaporation du solvant. Cette évaporation peut être effectuée notamment par une décompression du milieu réactionnel qui provoque l'évaporation de $CO_2$ et du solvant.

Selon une forme de réalisation particulière de l'invention, le procédé comprend entre outre une étape supplémentaire au cours de laquelle les particules récupérées par évaporation du solvant subissent une étape d'enrobage par un polymère. Cette étape est mise en oeuvre par exemple lorsque l'on souhaite enrober les particules de MTS par un polymère qui n'est pas soluble dans le solvant organique utilisé pour préparer la dispersion de particules avant la mise en contact avec $CO_2$ supercritique. Dans ce cas, cette étape supplémentaire peut être réalisée par toute technique d'enrobage connue de l'homme du métier, par exemple par pulvérisation d'une solution dudit polymère dans un solvant approprié sur la surface des particules, puis séchage ou bien encore, en milieu fluide supercritique en reproduisant le procédé de l'invention mais en utilisant cette fois un solvant dans lequel le polymère est soluble, ledit solvant étant alors différent de celui utilisé lors du premier traitement du matériau par le $CO_2$ supercritique.

Parmi les polymères susceptibles d'être utilisés dans le cadre de l'invention, on peut notamment citer les polymères thermoplastiques, les prépolymères des thermodurcissables incluant les polymères biodégradables. On préfère plus particulièrement le polyéthylèneglycol, le polybutadiène hydroxytéléchélique (PBHT), le polystyrène (PS), le polyméthylméthacrylate (PMMA) et le polychlorure de vinyle (PVC).

Les particules de matériau à transition de spin (II) utilisables selon le procédé de l'invention sont de préférence de taille nanométrique ou micrométrique.

Par particules "nanométriques", on entend des particules qui ont un diamètre moyen entre 1 nm et 500 nm, plus particulièrement entre 1 et 100 nm.

Par particules "micrométriques", on entend des particules qui ont un diamètre moyen entre 1 $\mu$m et 500 $\mu$m plus particulièrement entre 100 et 200 $\mu$m.

Un composé à transition de spin (I) est capable de changer d'état de spin de manière réversible lors d'un réchauffement et lors d'un refroidissement, avec un changement de couleur associé à chaque changement de spin. Lorsque w dans la formule (I) est respectivement 3, 300 ou 1500, la dimension moyenne des particules est respectivement d'environ 1 nm, 100 nm ou 500 nm.

Dans la suite du texte, un ligand "1,2,4-triazole portant un substituant R sur l'azote en position 4" est désigné indifféremment par L ou par R-Trz.

Un matériau (II) peut être constitué par un seul composé (II) ayant un ou plusieurs anions colorants différents, ou par un mélange d'au moins deux composés qui répondent à la définition donnée ci-dessus pour (II).

Dans un composé (II), X peut représenter un ou plusieurs anions, de préférence un ou deux anions $X^1$ et $X^2$. Les anions sont choisis parmi les anions monovalents ou les anions divalents. Un anion monovalent peut être choisi parmi $BF_4^-$, $ClO_4^-$, $Br^-$, $Cl^-$, $NO_3^-$, $CF_3SO_3^-$ et $CH_3SO_3^-$. Un anion divalent est choisi de préférence parmi $SO_4^{2-}$ et $CO_3^{2-}$. Comme exemples de mélange d'anions, on peut citer le couple $BF_4^-$ et $NO_3^-$, le couple $Br^-$ et $NO_3^-$, le couple $Cl^-$ et $NO_3^-$.

Y représente un ou plusieurs anions chromophores, de préférence un ou deux anions $Y^1$ et $Y^2$.

Un anion Y est choisi de préférence parmi les anions chromophores qui ont au moins deux cycles aromatiques et au moins un groupe $SO_3^-$. De tels anions sont fournis notamment par les composés dits "colorants acides" ou "colorants directs" ou "colorants brillants" ou "colorants à mordant".

L'anion Y de ces colorants peut comporter :

- un groupement azoïque, comme par exemple le C. I. Acid Orange 5 qui est le sel monosodique de l'acide 4-[[4-(phénylamino)-phényl]azo]benzènesulfonique, ou l'Acid Yellow 23 qui est la tartrazine, répondant à la formule :

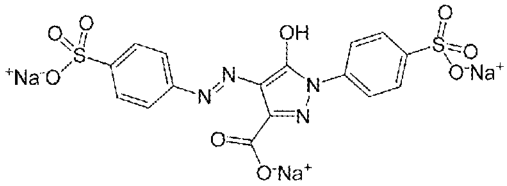

ou le Méthylorange ou Acid Orange 52 (hélianthine) répondant à la formule :

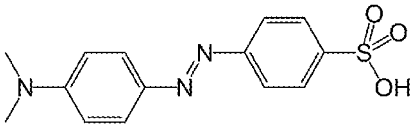

ou divers Direct Scarlet ; ou le C. I. Direct Blue 1, répondant à la formule :

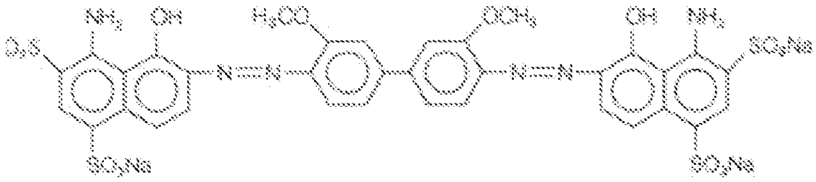

ou le C.I. Acid Red 27 répondant à la formule

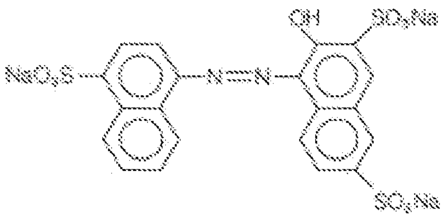

- un groupement dérivé d'une anthraquinone, par exemple le CI Reactive Blue 4 répondant à la formule :

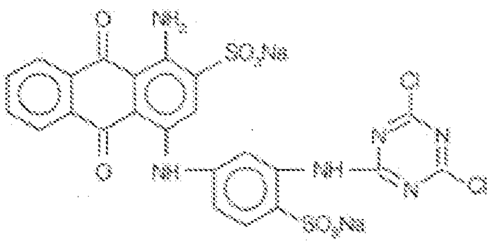

- un groupement dérivé d'une quinoline (C. I. Acid Yellow 3 ; D&C Yellow n° 30).

Dans un matériau (II), les proportions d'anions X et Y sont telles que la neutralité électronique du composé soit respectée.

La couleur de chaque état de spin d'un matériau (II) peut être ajustée en choisissant de manière appropriée le ou les anions X et Y, et en contrôlant leurs proportions respectives dans le matériau.

Il est nécessaire que la proportion d'anion colorant Y soit supérieure à un certain seuil afin d'éviter l'obtention d'un composé présentant une couleur rose à l'état bas spin et une couleur blanche à l'état haut spin.

Il est également nécessaire que la proportion d'anion colorant soit inférieure à un certain seuil au-delà duquel les couleurs correspondant à l'état bas spin et à l'état haut spin se distinguent difficilement.

Deux conditions sont à respecter :

1. un rapport molaire c/b (c'est-à-dire (nombre de mole de Y)/(nombre de mole de X) : il est inférieur ou égal à 0,1,

et supérieur ou égal à $10^{-5}$ ;

2. une concentration limite en anion Y, comprise de manière générale entre $10^{-7}$ et $5.10^{-4}$ mole/L (par exemple pour Patent Blue entre $4.10^{-7}$ et $2.10^{-4}$ mole/L, et pour la tartrazine, entre $2,2.10^{-7}$ et $1,1.10^{-4}$ mol/L).

Le matériau obtenu par le procédé de l'invention est constitué par des particules nanométriques ou micrométriques d'un matériau amorphe à transition de spin ayant la capacité de changer de phase de façon abrupte lors d'un écart de température inférieur ou égal à 10°C, de préférence inférieur ou égal à 8°C.

Ce matériau peut être caractérisé en étudiant ses propriétés de commutation optique et/ou magnétique selon les techniques adaptées bien connues de l'homme du métier.

Lorsque le solvant organique utilisé pour disperser les particules de MTS renferme en outre un polymère, ou que le procédé comprend une étape supplémentaire d'enrobage par un polymère, alors le matériau obtenu par le procédé de l'invention est constitué par des particules nanométriques ou micrométriques ayant un coeur constitué par un MTS ayant la capacité de changer de phase de façon abrupte lors d'un écart de température inférieur ou égal à 10°C, de préférence inférieur ou égal à 8°C et comportant un enrobage polymère.

Le matériau de la présente invention est particulièrement utile comme pigment thermochrome, dans le domaine des peintures et vernis, de la plasturgie, de la signalétique, de la décoration et de la sécurisation de données. Les particules de matériau à transition de spin obtenues par le procédé de l'invention ont une meilleure sensibilité à une variation de la température, qui se traduit par une augmentation du caractère abrupt de la transition. La sensibilité à une variation de température est une propriété recherchée pour un matériau destiné à être utilisé dans un indicateur de dépassement de seuil de température. En particulier, un écart de température aussi faible que 10°C, voire 8°C, permet d'engendrer la transition de phase, ce qui est particulièrement intéressant pour ce type d'application (contrôle de la chaîne du froid).

Le matériau sous forme de nanoparticules selon l'invention est en outre utile pour le stockage de données. Les nanoparticules constituent une véritable "mémoire moléculaire" utilisant le phénomène de transition de spin. Un bit d'information peut être ainsi stocké dans chaque nanoparticule. La parfaite transparence d'un disque constitué d'une matrice polymérique dopée par ces nanoparticules bistables permet d'envisager des applications dans le domaine du stockage de données en volume (holographie). La présente invention, en augmentant le caractère abrupt de la transition, permet donc d'accroître le domaine d'effet mémoire (largeur de l'hystérésis).

Des nanoparticules d'un matériau dont la réponse magnétique passe avec la température, d'une forme diamagnétique (état BS : bas spin) à paramagnétique (état HS : haut spin), peuvent être utilisées pour l'élaboration d'agents de contraste thermosensibles pour les procédés de thermothérapie. Les nanoparticules, placées *in situ,* permettraient de suivre le franchissement d'un seuil de température, tel que celui qui discrimine les cellules saines des cellules cancéreuses. En effet, l'image par résonance magnétique (IRM) d'un milieu contenant les nanoparticules est normale dans le cas des nanoparticules dans l'état BS diamagnétique et fortement distordue dans le cas d'un état HS paramagnétique. La présente invention en permettant d'accroître le caractère abrupt de la transition de spin représente une avancée significative.

Lorsque le MTS est constitué de particules contenant un pigment, leur enrobage par un polymère permet de modifier l'état de surface des particules et ainsi de jouer sur :

- la stabilité de la particule (domaine des pigments pour les peintures),
- l'ajout de fonctionnalité : greffage, amélioration de la tenue mécanique du pigment dans une matrice polymère (domaine des pigments dans des matrices polymères),
- la variation volumique entre les états BS et HS de la particule coeur peut être utilisée pour libérer une substance hôte encapsulé dans l'enrobage du polymère (domaine de la biologie),
- amélioration de la biocompatibilité (domaine de la biologie).

La présente invention est décrite plus en détails à l'aide des exemples qui suivent, qui sont donnés à titre d'illustration et auxquels l'invention n'est bien entendu pas limitée.

**Exemple 1**

On a dispersé 500 mg de particules de $[Fe(NH_2Trz)_3]Br_2$ ayant une dimension moyenne entre 100 et 250 $\mu$m dans 20 ml d'un solvant organique ayant une valeur de $\varepsilon$ entre 1,9 et 33,0. La dispersion ainsi obtenue a ensuite été introduite dans un réacteur haute pression haute température puis le milieu a été chauffé à la température désirée. On a alors introduit du $CO_2$ supercritique pour différentes conditions de température et de pression. Le système a été maintenu en l'état pendant une heure. On a ensuite effectué un balayage continu du réacteur avec du $CO_2$ supercritique en gardant constantes les conditions de pression et de température afin d'extraire le solvant du milieu. Enfin, on a décompressé le milieu et on a récupéré une poudre sèche constituée par des particules de $[Fe(NH_2Trz)_3]Br_2$.

On a ainsi reproduit l'essai avec différents solvants et différentes conditions de température et de pression.

Pour chacune des conditions testées, on a déterminé la modification de l'état de spin en fonction de la température lors d'un cycle chauffage/refroidissement.

Les résultats obtenus sont regroupés dans le tableau II ci-après :

**Tableau II**

| Essai | Solvant | ε | T (°C) | P (bars) | T.P | $\Delta T_{80/20\uparrow}$ (°C) | $\Delta T_{80/20\downarrow}$ (°C) | Caractère de la transition |
|---|---|---|---|---|---|---|---|---|
| 1 [a] | - | - | - | - | - | 32 | 32 | Transition graduelle (référence) |
| 2 [a] | - | - | 80 | 150 | 12000 | 30 | 31 | Id [b] |
| 3 [a] | - | - | 80 | 250 | 20000 | 29 | 29 | Id |
| 4 [a] | n-Hexane | 1,9 | 80 | 150 | 12000 | 21 | 21 | Id |
| 5 [a] | n-Hexane | 1,9 | 80 | 250 | 20000 | 31 | 30 | Id |
| 6 [a] | Acétate d'éthyle | 6,0 | 80 | 150 | 12000 | 23 | 22 | Id |
| 7 [a] | Acétate d'éthyle | 6,0 | 80 | 250 | 20000 | 15 | 11 | +[c] |
| 8 [a] | Acétate d'éthyle | 6,0 | 120 | 150 | 18000 | 18 | 18 | + |
| 9 [a] | Acétate d'éthyle | 6,0 | 120 | 250 | 30000 | 14 | 12 | + |
| 10 [a] | Dichlorométhane | 8,9 | 80 | 150 | 12000 | 23 | 21 | Id |
| 11 | Isopropanol | 19,9 | 40 | 150 | 6000 | 9 | 8 | + |
| 12 | Isopropanol | 19,9 | 80 | 15 | 12000 | 10 | 13 | + |
| 13 | Isopropanol | 19,9 | 80 | 250 | 20000 | 6 | 5 | abrupte |
| 14 | Acétone | 21,0 | 80 | 150 | 12000 | 8 | 12 | + |
| 15 | Acétone | 21,0 | 80 | 250 | 20000 | 4 | 7 | abrupte |
| 16 [a] | Ethanol | 25,3 | 40 | - | 0 | 20 | 17 | Id |
| 17 | Ethanol | 25,3 | 40 | 150 | 6000 | 17 | 17 | + |
| 18 | Ethanol | 25,3 | 80 | 150 | 12000 | 6 | 5 | abrupte |
| 19 | Ethanol | 25,3 | 80 | 250 | 20000 | 7 | 6 | abrupte |
| 20 | Ethanol | 25,3 | 120 | 150 | 18000 | 5 | 5 | abrupte |
| 21 | Méthanol | 33,0 | 80 | 150 | 12000 | 8 | 7 | abrupte |
| 22 | Méthanol | 33,0 | 80 | 250 | 20000 | 7 | 4 | abrupte |
| 23 | Acétonitrile | 38 | 80 | 150 | 12000 | 7 | 8 | abrupte |

[a] : essai à but comparatif ne faisant pas partie de l'invention
[b] : Id = transition de spin identique à la référence,
[c] : Légère amélioration de la pente, la transition devient plus abrupte.

Dans ce tableau, l'essai n°1 correspond au matériau de référence, c'est-à-dire aux particules de $[Fe(NH_2Trz)_3]Br_2$ n'ayant subi aucun traitement et les essais n° 2 et 3, correspondent aux résultats obtenus avec des particules de $[Fe(NH_2Trz)_3]Br_2$ ayant été soumises aux conditions de température et de pression indiquées dans le tableau ci-dessus mais sans disperser les particules dans un solvant.

Les résultats obtenus démontrent que le choix d'un solvant ayant un ε > 19 et des conditions de température (T) et de pression (P) est crucial pour obtenir des particules d'un matériau à transition de spin ayant un $\Delta T_{80/20\uparrow}$ et/ou un $\Delta T_{80/20\downarrow}$ inférieur ou égal à 10°C.

**Exemple 2**

Préparation d'un matériau à transition de spin en milieu fluide supercritique

On a dispersé 200 mg de particules de $[Fe(NH_2Trz)_3]Cl_2$ ayant une dimension moyenne entre 100 et 250 μm dans 10 ml d'éthanol. La dispersion ainsi obtenue a ensuite été introduite dans un réacteur haute pression haute température puis le milieu a été chauffé jusqu'à 80°C. On a alors introduit du $CO_2$ supercritique jusqu'à une pression de 15 MPa. Le système a été maintenu en l'état pendant une heure. On a ensuite effectué un balayage continu du réacteur avec du $CO_2$ supercritique en gardant constantes les conditions de pression et de température afin d'extraire le solvant du milieu. Enfin, on a décompressé le milieu et on a récupéré une poudre sèche constituée par des particules de $[Fe(NH_2Trz)_3]Cl_2$.

On a déterminé la modification de l'état de spin en fonction de la température lors d'un cycle chauffage/refroidissement.

Les résultats obtenus sont regroupés dans le tableau III ci-après :

**Tableau III**

| Essai | Solvant | ε | T (°C) | P (bars) | T.P | $\Delta T_{80/20\uparrow}$ (°C) | $\Delta T_{80/20\downarrow}$ (°C) | Caractère de la transition |
|---|---|---|---|---|---|---|---|---|
| 1 | - | - | - | - | - | 23 | 24 | Transition graduelle (référence) |
| 2 | Ethanol | 25,3 | 80 | 150 | 12000 | 5 | 7 | abrupte |

**Exemple 3**

Préparation du matériau (P.C.A.)

On a dissous 54 mg de polyéthylène glycol ayant une masse moléculaire de 2000 (PEG 2000) dans 100 mL d'éthanol, et on a dispersé dans la solution obtenue, 523 mg de particules analogues à celles utilisées ci-dessus à l'exemple 1. Ensuite, on a pulvérisé la dispersion dans du $CO_2$ supercritique (40°C, 150 bars) avec un débit de 4 mL/min.

On a décompressé le milieu réactionnel, le solvant a été extrait par le $CO_2$, et on a récupéré une poudre sèche constituée par des particules de $[Fe(NH_2Trz)_3]Br_2$ enrobées par le PEG 2000.

Caractérisation

Le matériau obtenu a été caractérisé par réflectivité optique. La figure 1 représente la modification de l'état de spin en fonction de la température lors d'un cycle chauffage/refroidissement, d'une part pour le composé obtenu selon le présent exemple, et d'autre part pour le composé $[Fe(NH_2Trz)_3]Br_2$ non traité. Le pourcentage de transmission de spin (%R) est donné en ordonnée, et la température T en degrés Kelvin (T/K) est donnée en abscisse. La courbe b) en trait plein correspond au matériau de l'invention, et la courbe a) en traits discontinus correspond au matériau $[Fe(NH_2Trz)_3]Br_2$ non traité. Ces courbes montrent l'effet du traitement par $CO_2$SC dans les conditions de l'invention, d'une part sur le caractère abrupt de la transition, et d'autre part sur l'hystérésis.

**Exemple 4**

Préparation du matériau (P.C.A.)

On a dissous 60 mg de polyéthylène glycol ayant une masse moléculaire de 2000 (PEG 2000) dans 100 mL d'éthanol, et on a dispersé dans la solution obtenue, 634 mg de particules de $[Fe(NH_2Trz)_3]Br_2$ ayant une dimension de particules de l'ordre de 200 nm. Ensuite, on a pulvérisé la dispersion dans du $CO_2$ supercritique (40°C, 150 bars) avec un débit de 4 mL/min.

On a décompressé le milieu réactionnel, le solvant a été extrait par le $CO_2$, et on a récupéré une poudre sèche constituée par des particules de $[Fe(NH_2Trz)_3]Br_2$ enrobées par le PEG 2000.

Caractérisation

La figure 2 représente le pourcentage de transition de spin mesuré par réflectivité optique (%R) en fonction de la température en degrés Kelvin (T/K) lors d'un cycle chauffage/refroidissement, d'une part pour le composé obtenu selon le présent exemple, et d'autre part pour le composé $[Fe(NH_2Trz)_3]Br_2$ non traité. La courbe b) en trait plein

correspond au matériau de l'invention, et la courbe a) en traits discontinus correspond au matériau $[Fe(NH_2Trz)_3]Br_2$ non traité. Comme dans l'exemple précédent, les courbes montrent l'effet du traitement d'une part sur le caractère abrupt de la transition, et d'autre part sur l'hystérésis.

**Exemple 5**

Préparation de divers MTS en milieu fluide supercritique

On a dissous 50 mg de polyéthylène glycol ayant une masse moléculaire de 2000 (PEG 2000) dans 100 mL d'éthanol, et on a dispersé dans la solution obtenue, 500 mg de particules de divers MTS. Ensuite, on a pulvérisé la dispersion dans du $CO_2$ supercritique (75°C, 150 bars) avec un débit de 2 mL/min.

On a alors décompressé le milieu réactionnel, le $CO_2$ a entrainé le solvant, et on a récupéré une poudre sèche constituée par des particules de MTS enrobées par le PEG 2000.

Le matériau obtenu a été caractérisé par réflectivité optique.

Les résultats obtenus sont regroupés dans le tableau IV ci-après :

**Tableau IV**

| Essai | Nature du MTS | Polymère | Solvant | $\Delta T$ 80/20↑ (°C) | $\Delta T$ 80/20↓ (°C) | Caractère de la transition |
|---|---|---|---|---|---|---|
| 1 | $[Fe(MeTrz)_3]BF_4$ | - | - | 7,5 | 5 | Transition abrupte (référence) |
| 2 | $[Fe(MeTrz)_3]BF_4$ | PEG 2000 | Ethanol | 3,7 | 2,3 | Encore + abrupte |
| 3 | $[Fe(NH_2Trz)_3]Br_2$ contenant un pigment bleu | - | - | 10 | 9,5 | Transition abrupte (référence) |
| 4 | $[Fe(NH_2Trz)_3]Br_2$ contenant un pigment bleu | PEG 2000 | Ethanol | 7 | 4 | Encore + abrupte |

**Revendications**

**1.** Procédé de préparation d'un matériau à transition de spin sous forme de particules, **caractérisé en ce qu'**il consiste :

- dans une première étape, à préparer une dispersion de particules d'un matériau à transition de spin dans un solvant organique polaire dont la constante diélectrique, mesurée à 25°C, est supérieure à 19, puis
- dans une deuxième étape, à réaliser une mise en contact de la dispersion de particules ainsi obtenue avec du $CO_2$ supercritique à une température T et à une pression P remplissant les trois conditions suivantes :

1) $40 \leq T \leq 150°C$;
2) $150 \leq P \leq 250$ bars et
3) $P.T > 6000$,

et **en ce que** le matériau à transition de spin est choisi parmi un matériau (II) constitué par au moins un composé répondant à la formule (II) suivante :

$$AX_bY_c \qquad (II)$$

dans laquelle :

- A répond à la formule $Fe(R\text{-}Trz)_3$ ;
- R-Trz représente un ligand 1,2,4-triazole portant un substituant R sur l'azote en position 4 ;
- R est un groupe méthyle ou un groupe $R^1R^2N$- dans lequel $R^1$ et $R^2$ représentent chacun indépendamment de l'autre H ou un radical méthyle ;
- X représente au moins un anion monovalent ou divalent ;

- Y représente au moins un anion qui a un groupe chromophore ;
- b et c sont choisis de telle sorte que l'électroneutralité du composé (II) soit respectée, et

un matériau (I) constitué par des particules nanométriques comprenant essentiellement un composé répondant à la formule (I) suivante :

$$\left[(FeL_3)_w L_3\right]\left[X'_{2/x(1-z/x')}\,Y'_{2z/x'}\right]_w \quad \text{(I)}$$

dans laquelle :

- L représente un ligand 1,2,4-triazole portant un substituant R sur l'azote en position 4 ;
- X' est un anion ayant la valence x, $1 \leq x \leq 2$ ;
- Y' est un anion différent de X ayant la valence x', $1 \leq x' \leq 2$ ;
- R est un groupe méthyle ou un groupe $R^1R^2N$- dans lequel $R^1$ et $R^2$ représentent chacun indépendamment de l'autre H ou un radical méthyle ;
- $0 \leq z \leq 2$ et $3 \leq w \leq 1500$.

**2.** Procédé selon la revendication 1, **caractérisé en ce que** le solvant polaire a une constante diélectrique telle que $19 < \varepsilon \leq 25$, et **en ce que** la température et la pression sont choisies de telle sorte que le produit P.T soit supérieur ou égal à 12000.

**3.** Procédé selon la revendication 1, **caractérisé en ce que** le solvant polaire a une constante diélectrique $\varepsilon > 25$, et **en ce que** la température et la pression sont choisies de telle sorte que le produit P.T soit supérieur ou égal à 10000.

**4.** Procédé selon l'une quelconque des revendications précédentes, **caractérisé en ce que** le solvant organique est choisi parmi les solvants dont la constante diélectrique $\varepsilon$ est inférieure ou égale à 40.

**5.** Procédé selon l'une quelconque des revendications précédentes, **caractérisé en ce que** le solvant organique est choisi parmi l'isopropanol ($\varepsilon$ = 20,2), l'acétone ($\varepsilon$ = 21,0), l'éthanol ($\varepsilon$ = 25,3), le méthanol ($\varepsilon$ = 33), le diméthylformamide ($\varepsilon$ = 37) et l'acétonitrile ($\varepsilon$ = 38).

**6.** Procédé selon l'une quelconque des revendications précédentes, **caractérisé en ce que** la mise en contact est effectuée par pulvérisation de $CO_2SC$ dans la dispersion de particules.

**7.** Procédé selon l'une quelconque des revendications 1 à 5, **caractérisé en ce que** la mise en contact est effectuée par pulvérisation, dans $CO_2SC$, du solvant dans lequel les particules ont été dispersées.

**8.** Procédé selon l'une quelconque des revendications précédentes, **caractérisé en ce que** le solvant organique renferme en outre un polymère et **en ce que** ledit procédé comprend une étape supplémentaire au cours de laquelle au moins un polymère est dissous dans le solvant organique avant d'y disperser les particules.

**9.** Procédé selon la revendication 8, **caractérisé en ce que** le ou les polymères représentent de 0,1 à 15 % en poids par rapport au poids total des particules du matériau à transition de spin dispersées dans le solvant.

**10.** Procédé selon l'une quelconque des revendications précédentes, **caractérisé en ce qu'**à l'issue de l'étape de mise en contact avec $CO_2SC$, les particules du matériau à transition de spin sont récupérées par évaporation du solvant.

**11.** Procédé selon l'une quelconque des revendications précédentes, **caractérisé en ce qu'**il comprend en outre une étape supplémentaire au cours de laquelle les particules récupérées par évaporation du solvant subissent une étape d'enrobage par un polymère.

**12.** Procédé selon l'une quelconque des revendications 8 à 11, **caractérisé en ce que** le polymère est choisi parmi le polyéthylèneglycol, le polybutadiène hydroxytéléchélique, le polystyrène, le polyméthylméthacrylate et le polychlorure de vinyle.

**13.** Procédé selon l'une quelconque des revendications précédentes, **caractérisé en ce que** les particules du matériau à transition de spin (II) ont une taille nanométrique ou micrométrique.

**14.** Procédé selon l'une quelconque des revendications précédentes, **caractérisé en ce que** Y est choisi parmi les anions chromophores qui ont au moins deux cycles aromatiques et au moins un groupe $SO_3^-$.

**15.** Utilisation d'un matériau obtenu selon le procédé défini à l'une quelconque des revendications 1 à 14, ledit matériau étant constitué par des particules nanométriques ou micrométriques d'un matériau amorphe à transition de spin ayant la capacité de changer de phase de façon abrupte lors d'un écart de température inférieur ou égal à 10°C, comme pigment thermochrome, pour le stockage de données, ou pour l'élaboration d'agents de contraste thermosensibles pour les procédés de thermothérapie.

**16.** Utilisation selon la revendication 15, comme pigment thermochrome dans un indicateur de dépassement de seuil de température.

**17.** Utilisation selon la revendication 15 ou 16, **caractérisée en ce que** le matériau comporte un enrobage polymère.

**Patentansprüche**

**1.** Verfahren zur Herstellung eines Spinübergangsmaterials in Form von Partikeln, **dadurch gekennzeichnet, dass** es darin besteht:

- in einem ersten Schritt, Vorbereiten einer Dispersion von Partikeln eines Spinübergangsmaterials in einem polaren organischen Lösungsmittel, dessen dielektrische Konstante, gemessen bei 25 °C, größer als 19 ist, danach
- in einem zweiten Schritt, Durchführen einer Inkontaktverbringung der derart hergestellten Partikeldispersion mit superkritischem $CO_2$ bei einer Temperatur T und einem Druck P, die die folgenden drei Bedingungen erfüllen:

1) $40 \leq T \leq 150°C$,
2) $150 \leq P \leq 250$ bar und
3) $P.T > 6000$,

und dass das Spinübergangsmaterial aus einem Material (II) ausgewählt ist, das mindestens aus einer Verbindung besteht, die der folgenden Formel (II) entspricht:

$$AX_bY_c \qquad (II)$$

wobei:

- A der Formel $Fe(R\text{-}Trz)_3$ entspricht,
- R-Trz einen 1,2,4-Triazolliganden darstellt, der einen Substituenten R auf dem Stickstoff in Position 4 trägt,
- R eine Methylgruppe oder eine Gruppe $R^1R^2N$- ist, wobei $R^1$ und $R^2$ jeweils unabhängig voneinander H oder ein Methylradikal darstellen,
- X mindestens ein einwertiges oder zweiwertiges Anion darstellt,
- Y mindestens ein Anion mit einer chromophoren Gruppe darstellt,
- b und c derart ausgewählt sind, dass die Elektroneutralität der Verbindung (II) respektiert ist, und

einem Material (I), das aus Nanometerpartikeln besteht, die im Wesentlichen eine Verbindung umfassen, die der folgenden Formel (I) entspricht:

$$\left[(FeL_3)_n L_3\right]\left[X'_{2/x(1-y/x)} Y'_{2y/x}\right]_n \qquad (I)$$

wobei:

- L einen 1,2,4-Triazolliganden darstellt, der einen Substituenten R auf dem Stickstoff in Position 4 trägt,
- X' ein Anion mit der Wertigkeit x ist, $1 \leq x \leq 2$,
- Y' ein Anion ist, das sich von X unterscheidet, mit der Wertigkeit x', $1 \leq x' \leq 2$,
- R eine Methylgruppe oder eine Gruppe $R^1R^2N$- ist, wobei $R^1$ und $R^2$ jeweils unabhängig voneinander H oder ein Methylradikal darstellen,
- $0 \leq z \leq 2$ und $3 \leq w \leq 1500$.

**2.** Verfahren nach Anspruch 1, **dadurch gekennzeichnet, dass** das polare Lösungsmittel eine dielektrische Konstante wie $19 < \varepsilon \leq 25$ hat und dass die Temperatur und der Druck derart gewählt sind, dass das Produkt P.T größer oder gleich 12000 ist.

**3.** Verfahren nach Anspruch 1, **dadurch gekennzeichnet, dass** das polare Lösungsmittel eine dielektrische Konstante $\varepsilon > 25$ hat und dass die Temperatur und der Druck derart gewählt sind, dass das Produkt P.T größer oder gleich 10000 ist.

**4.** Verfahren nach einem der vorangehenden Ansprüche, **dadurch gekennzeichnet, dass** das organische Lösungsmittel aus den Lösungsmitteln ausgewählt ist, deren dielektrische Konstante $\varepsilon$ kleiner oder gleich 40 ist.

**5.** Verfahren nach einem der vorangehenden Ansprüche, **dadurch gekennzeichnet, dass** das organische Lösungsmittel aus dem Isopropanol ($\varepsilon$ = 20,2), dem Aceton ($\varepsilon$ = 21,0), dem Ethanol ($\varepsilon$ = 25,3), dem Methanol ($\varepsilon$ = 33), dem Dimethylformamid ($\varepsilon$ = 37) und dem Acetonitril ($\varepsilon$ = 38) ausgewählt ist.

**6.** Verfahren nach einem der vorangehenden Ansprüche, **dadurch gekennzeichnet, dass** das Inkontaktversetzen durch Zerstäuben von $CO_2SC$ in die Partikeldispersion erfolgt.

**7.** Verfahren nach einem der Ansprüche 1 bis 5, **dadurch gekennzeichnet, dass** das Inkontaktversetzen durch Zerstäuben des Lösungsmittels, in dem die Partikel dispergiert wurden, in $CO_2SC$ erfolgt.

**8.** Verfahren nach einem der vorangehenden Ansprüche, **dadurch gekennzeichnet, dass** das organische Lösungsmittel ferner ein Polymer einschließt und dass das Verfahren einen zusätzlichen Schritt umfasst, bei dem mindestens ein Polymer in dem organischen Lösungsmittel gelöst wird, bevor dort die Partikel dispergiert werden.

**9.** Verfahren nach Anspruch 8, **dadurch gekennzeichnet, dass** das oder die Polymere im Verhältnis zum Gesamtgewicht der Partikel des Spinübergangsmaterials, die im Lösungsmittel dispergiert sind, 0,1 bis 15 Gew.-% darstellen.

**10.** Verfahren nach einem der vorangehenden Ansprüche, **dadurch gekennzeichnet, dass** die Partikel des Spinübergangsmaterials nach Abschluss des Schritts des Inkontaktversetzens mit $CO_2SC$ durch Evaporation des Lösungsmittels zurückgewonnen werden.

**11.** Verfahren nach einem der vorangehenden Ansprüche, **dadurch gekennzeichnet, dass** es ferner einen zusätzlichen Schritt umfasst, bei dem die durch Evaporation des Lösungsmittels zurückgewonnenen Partikel einen Umhüllungsschritt durch ein Polymer absolvieren.

**12.** Verfahren nach einem der Ansprüche 8 bis 11, **dadurch gekennzeichnet, dass** das Polymer aus dem Polyethylenglycol, dem hydroxylterminierten Polybutadien, dem Polystyrol, dem Polymethylmethacrylat und dem Vinylpolychlorid ausgewählt ist.

**13.** Verfahren nach einem der vorangehenden Ansprüche, **dadurch gekennzeichnet, dass** die Partikel des Spinübergangsmaterials (II) eine nanometrische oder mikrometrische Größe haben.

**14.** Verfahren nach einem der vorangehenden Ansprüche, **dadurch gekennzeichnet, dass** Y aus den chromophoren Anionen ausgewählt ist, die mindestens zwei aromatische Ringe und mindestens eine Gruppe $SO_3^-$ haben.

**15.** Verwendung eines Materials, das nach dem Verfahren nach einem der Ansprüche 1 bis 14 hergestellt ist, wobei dieses Material von nanometrischen oder mikrometrischen Partikeln eines amorphen Spinübergangsmaterials gebildet ist mit der Fähigkeit, bei einer Temperaturabweichung unter oder gleich 10 °C die Phase abrupt zu ändern, als thermochormes Pigment für die Speicherung von Daten oder für die Erzeugung von thermosensiblen Kontrastmitteln für Thermotherapieverfahren.

**16.** Verwendung nach Anspruch 15 als Thermochromes Pigment in einer Temperaturgrenzwertüberschreitungsanzeige.

**17.** Verwendung nach Anspruch 15 oder 16, **dadurch gekennzeichnet, dass** das Material eine Polymerhülle aufweist.

## Claims

**1.** A method for preparing a material with spin transition in the form of particles, **characterized in that** it consists of:

- in a first step, preparing a dispersion of particles of a spin transition material in a polar organic solvent, the dielectric constant of which, measured at 25°C, is greater than 19, and then
- in a second step, achieving contact of the thereby obtained dispersion of particles with supercritical $CO_2$ at a temperature T and at a pressure P fulfilling the three following conditions:

1) $40 \leq T \leq 150°C$;
2) $150 \leq P \leq 250$ bars and
3) $P.T > 6,000$,

**in that** the spin transition material is selected from a material (II) formed by at least one compound fitting the following formula (II):

$$AX_bY_c \qquad (II)$$

wherein:

- A fits the formula $Fe(R\text{-}Trz)_3$;
- R-Trz represents a 1,2,4-triazole ligand bearing a substituent R on the nitrogen atom in position 4;
- R is a methyl group or a group $R^1R^2N$- wherein $R^1$ and $R^2$ each represent independently of each other H or a methyl radical;
- X represents at least one monovalent or divalent anion;
- Y represents at least one anion which is a chromophore group;
- b and c are selected so that the electroneutrality of the compound (II) is observed, and

a material (I) formed by nanometric particles essentially comprising a compound fitting the following formula (I):

$$\left[(FeL_3)_w L_3\right]\left[X'_{2/x(1-z/x')} Y'_{2\tau/x'}\right]_w \qquad (I)$$

wherein:

- L represents a 1,2,4-triazole ligand bearing a substituent R on the nitrogen atom in position 4;
- X' is an anion with valence x, $1 \leq x \leq 2$;
- Y' is an anion different from X with the valence x', $1 \leq x', \leq 2$;
- R is a methyl group or a group $R^1R^2N$- wherein $R^1$ and $R^2$ each represent independently of each other H or a methyl radical;
- $0 \leq z \leq 2$ and $3 \leq w \leq 1500$.

**2.** The method according to claim 1, **characterized in that** the polar solvent has a dielectric constant such that $19 < \varepsilon \leq 25$, and **in that** the temperature and the pressure are selected so that the product P.T is greater than or equal to 12,000.

**3.** The method according to claim 1, **characterized in that** the polar solvent has a dielectric constant $\varepsilon > 25$, and **in that** the temperature and the pressure are selected so that the product P.T is greater than or equal to 10,000.

**4.** The method according to any of the preceding claims, **characterized in that** the organic solvent is selected from solvents for which the dielectric constant $\varepsilon$ is less than or equal to 40.

5. The method according to any of the preceding claims, **characterized in that** the organic solvent is selected from isopropanol ($\varepsilon$ = 20.2), acetone ($\varepsilon$ = 21.0), ethanol ($\varepsilon$ = 25.3), methanol ($\varepsilon$ = 33), dimethylformamide ($\varepsilon$ = 37) and acetonitrile ($\varepsilon$ = 38).

6. The method according to any of the preceding claims, **characterized in that** the contacting is carried out by spraying $CO_2SC$ into the dispersion of particles.

7. The method according to any of claims 1 to 5, **characterized in that** the contacting is carried out by spraying, in $CO_2SC$, of the solvent in which the particles have been dispersed.

8. The method according to any of the preceding claims, **characterized in that** the organic solvent further contains a polymer and said method comprises an additional step during which at least one polymer is dissolved in the organic solvent before dispersing the particles therein.

9. The method according to claim 8, characterizing that the polymer(s) represent from 0.1 to 15% by weight based on the total weight of the particles of the spin transition material, dispersed in the solvent.

10. The method according to any of the preceding claims, **characterized in that** at the end of the step for contact with $CO_2SC$, the particles of the spin transition material are recovered by evaporation of the solvent.

11. The method according to any of the preceding claims, **characterized in that** it further comprises an additional step during which the particles recovered by evaporation of the solvent are subject to a step for coating with a polymer.

12. The method according to any of claims 8 to 11, **characterized in that** the polymer is selected from polyethylene glycol, hydroxytelechelic polybutadiene, polystyrene, polymethyl methacrylate and polyvinyl chloride.

13. The method according to any of the preceding claims, **characterized in that** the particles of the spin transition material (II) have a nanometric or micrometric size.

14. The method according to any of the preceding claims, **characterized in that** Y is selected from chromophore anions which have at least two aromatic rings and at least one group $SO_3^-$.

15. The use of a material obtained according to the method defined in any of claims 1 to 14, said material being formed with nanometric or micrometric particles of an amorphous spin transition material having the capability of changing phase in a sudden way upon a temperature difference of less than or equal to 10°C, as a thermochromic pigment, for storing data, or for elaborating thermosensitive contrast agents for thermotherapy methods.

16. The use according to claim 15, as a thermochromic pigment, in an indicator of the upward crossing of a temperature threshold.

17. The use according to claim 15 or 16, **characterized in that** the material includes a polymeric coating.

Fig. 1

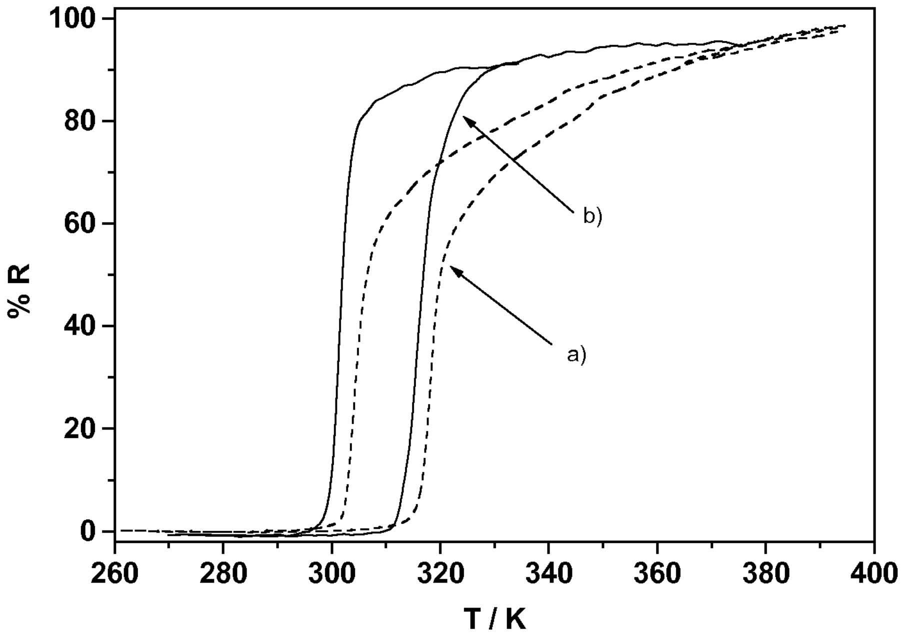
100
80
60
40
20
0
% R
260
280
300
320
340
360
380
400
T / K
b)
a)

Fig. 2

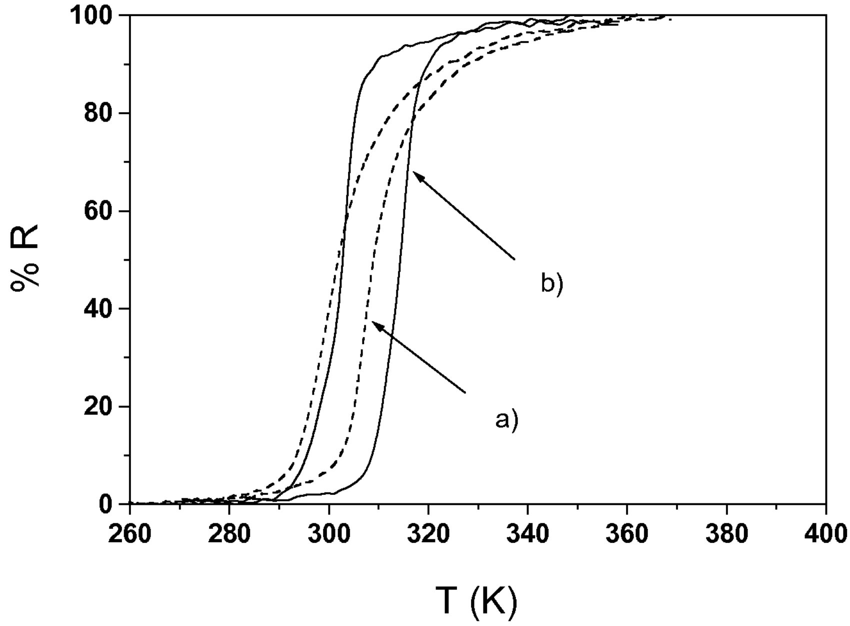
100
80
60
40
20
0
% R
260
280
300
320
340
360
380
400
T (K)
b)
a)

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- EP 0543465 A
- EP 0666561 A
- EP 0745986 A
- EP 0842988 A
- WO 2007065996 A
- FR 2917410


### Littérature non-brevet citée dans la description


- **ARNAUD et al.** *Chem. Phys. Lett.,* 2009, vol. 470, 131-135
- **AYMONIER et al.** *J. Supercritical Fluids,* 2006, vol. 38 (2), 242-252